Europäisches Patentamt

European Patent Office

Office européen des brevets

(19)

(11) Publication number: **0 028 491**

## EUROPEAN PATENT SPECIFICATION

(12)

(45) Date of publication of patent specification: **27.07.83**

(51) Int. Cl.³: **H 03 H 9/09**

(21) Application number: **80303808.2**

(22) Date of filing: **27.10.80**

(54) **Electrical connector for mounting a flat transducer on a printed circuit board.**

(30) Priority: **05.11.79 US 91672**

(43) Date of publication of application:
**13.05.81 Bulletin 81/19**

(45) Publication of the grant of the patent:
**27.07.83 Bulletin 83/30**

(84) Designated Contracting States:
**AT BE CH DE FR GB IT LI NL SE**

(56) References cited:
**DE - A - 2 951 396**
**GB - A - 1 073 600**
**US - A - 3 066 367**

(73) Proprietor: **AMP INCORPORATED**
**Eisenhower Boulevard**
**Harrisburg Pennsylvania (US)**

(72) Inventor: **Myers, Ronald William**
**R.D. No.1 Box 431**
**Landisburg Pennsylvania 17040 (US)**
Inventor: **Nardone, Daniel Vincent**
**2095 Clarendon Street**
**Camp Hill Pennsylvania 17011 (US)**

(74) Representative: **Stuart-Prince, Richard Geoffrey**
**20 Queensmere**
**Slough, Berkshire SL1 1YZ (GB)**

Courier Press, Leamington Spa, England

Electrical connector for mounting a flat transducer on a printed circuit board

The invention relates to an electrical connector for mounting a flat piezo-electric transducer on a printed circuit board.

It is often desirable to mount a flat, usually disc-form, piezo-electric transducers on printed circuit boards with the planes of the transducers parallel to the surface of the printed circuit boards.

A known electrical connector for mounting a flat piezo-electric transducer on a printed circuit board comprises first and second stamped and formed metal strip portions having a plurality of coplanar, perimetrically spaced, hook-forming portion adjacenet their ends, at least one of which strip portions is resilient, the strip portions being adapted to be connected to the printed circuit board with the plane containing the hook-forming portions parallel to the printed circuit board, a resilient contact arm adapted to be connected to upstand from the printed circuit board surrounded by the hook-forming portions, the arrangement being such that the resilient flexure of the or each strip portion relatively apart to enlarge the perimeter will permit engagement of an edge portion of the transducer by all the hook-forming portions with a central portion of the transducer depressing the contact arm.

In the known connector, the resilient strip portion is bent to extend perpendicularly to the plane of the hook-forming portions, which is disadvantageous as a requirement for a long resilient strip member to provide a relatively soft spring action would conflict with a requirement for minimal connector height to permit close stacking of printed circuit boards overlying relation.

In addition, the bending of the strip member would tend to produce an inelastic set adjacent the bend axis which would be particularly significant where the resilient strip member is short to meet the requirement for a connector of low height.

In a connector according to the invention, the resilient strip portion extends with its longitudinal axis parallel to the plane containing the hook-forming portions for resilient flexure parallel to the plane of the printed circuit board.

An increase in length of the resilient strip member will not therefore result in a corresponding increase in connector height enabling a soft spring action to be obtained together with a connector of relatively low height.

Specific examples of electrical connectors according to the invention will now be described with reference to the accompanying drawings in which:—

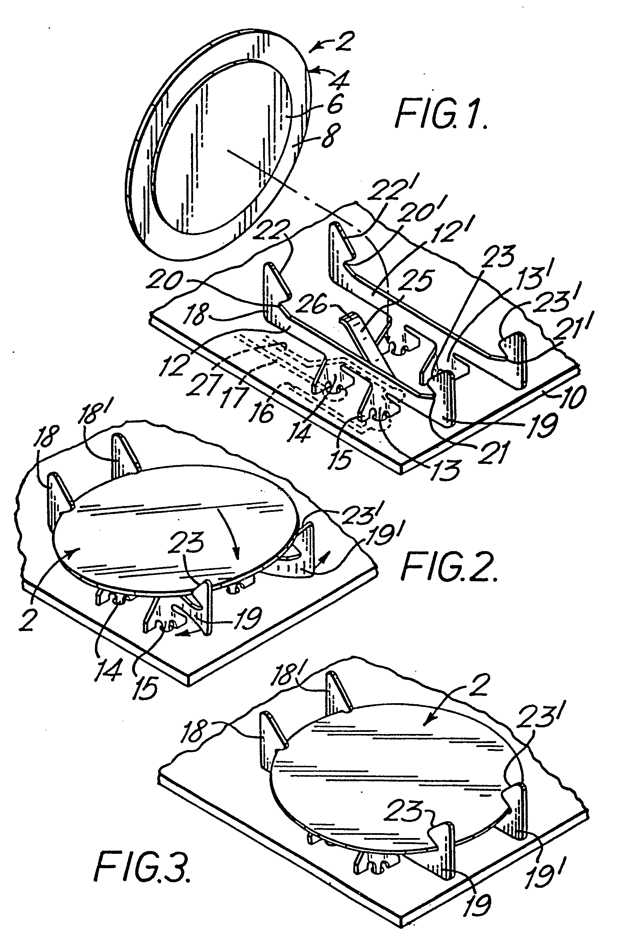

Figure 1 is a perspective view of a first example of a connector mounted on a printed circuit board and of a transducer suitable for use with the connector;

Figure 2 is a similar view to Figure 1 showing the transducer and connector of Figure 1 during assembly;

Figure 3 is a similar view to Figure 1 showing the transducer and connector fully assembled together;

Figure 4 is a perspective view of a second example of connector aligned for mounting on a printed circuit board;

Figure 5 is a similar view to Figure 4 showing the connector mounted on the printed circuit board;

Figure 6 is a similar view to Figure 4 showing a transducer, assembled with the connector;

Figure 7 is a cross-sectional view taken along the central longitudinal axis of the connector when mounted on the printed circuit board; and,

Figure 8 is a plan view of a strip of conductors shown in Figure 4.

A particular example of flat piezo-electric transducer 2 suitable for use with the connector comprises a thin sheet metal disc 4 having a circular body 6 of piezo-electric material centrally thereon.

The body is of smaller diameter than the disc to leave a peripheral circular edge portion 8 of bare metal surrounding the body.

The first example of connector comprises a pair of identical stamped and formed resilient metal strips 12, 12′ from a central part of one longitudinal edge each of which extend transversely a pair of longitudinally spaced solder tabs 13 and 14 and associated steadying feet 15 and 16. The strips are formed at respective opposite ends with coplanar laterally extending ears 18, 18′ and 19, 19′ provided with opposed hook forming notches 20, 21 and 20′ 21′, respectively, with camming guide surfaces 22, 23 and 22′, 23′, respectively, extending from the remote ends of the ears to the notches. The root ends of the notches should preferably be of less thickness than the metal disc.

The strips 12, 12′ are mounted in parallel, spaced apart relation on a printed circuit board 10 with their longitudinal axes parallel to, and their planes perpendicular to, the printed circuit board by the solder tabs being received in board apertures in connection with circuit paths 17.

When the strips are so mounted, the four notches 20, 21, 20′, 21′ are substantially coplanar and lie on the circumference of a circular ring having substantially the same diameter as the metal disc 4. A resilient metal contact arm 25 is mounted in the printed circuit board centrally between the strips 12, 12′ in connection with the circuit path 27 and has a contact portion protruding above the plane of the notches.

According to one method of assembling the transducer with the connector, an edge portion of the transducer is inserted into a pair of adjacent notches 20 and 20′ at one end of each metal strip with the piezo-electric body facing towards the printed circuit board and the opposite edge portion is pressed down on the camming guide surfaces 22 and 23 at the opposite end of the strips thereby to urge the opposite ends resiliently apart to permit the edge portion to snap into the notches. The transducer edge is thereby trapped in each notch with the metal ring 8 electrically connected to the strips 12, 12' and the piezo-electric body resiliently depressing the contact arm 25 to establish electrical connection therewith.

It should be noted that, during assembly, the strips are urged apart in the plane of the board i.e. perpendicular to their own planes enabling relatively long cantilever spring arms to be obtained with a soft, reliable, spring action and with minimum projection above the surface of the printed circuit board. Risk of damage to the transducer is thereby minimised and printed circuit boards on which the connectors are mounted can be stacked closely overlying each other, often a requirement in electronics equipment.

In addition, no tools are required to effect assembly and the transducer can readily be released by manually flexing the ends of the respective strips apart.

Whilst variations of the transducer diameter can be accommodated within limits by the relatively soft spring action with the strips 12, 12' fixed a predetermined distance apart, altering their separation will enable transducers having a relatively large range of different diameters to be accommodated.

Although it is preferred to mount the strips in parallel relation, the strips may be mounted in intersecting planes, where it is required to provide clearance for other components on the printed circuit board.

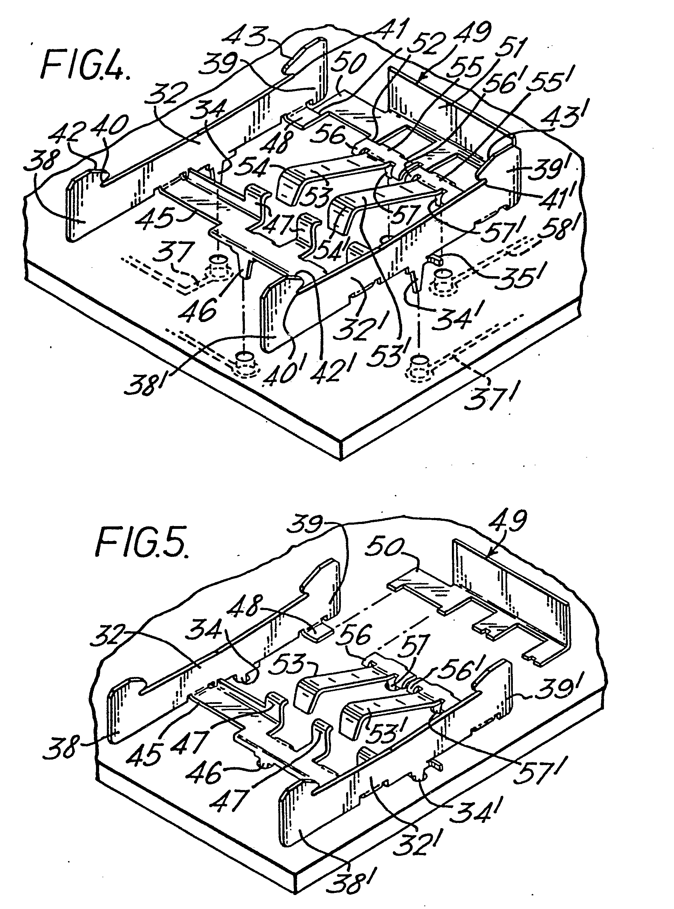

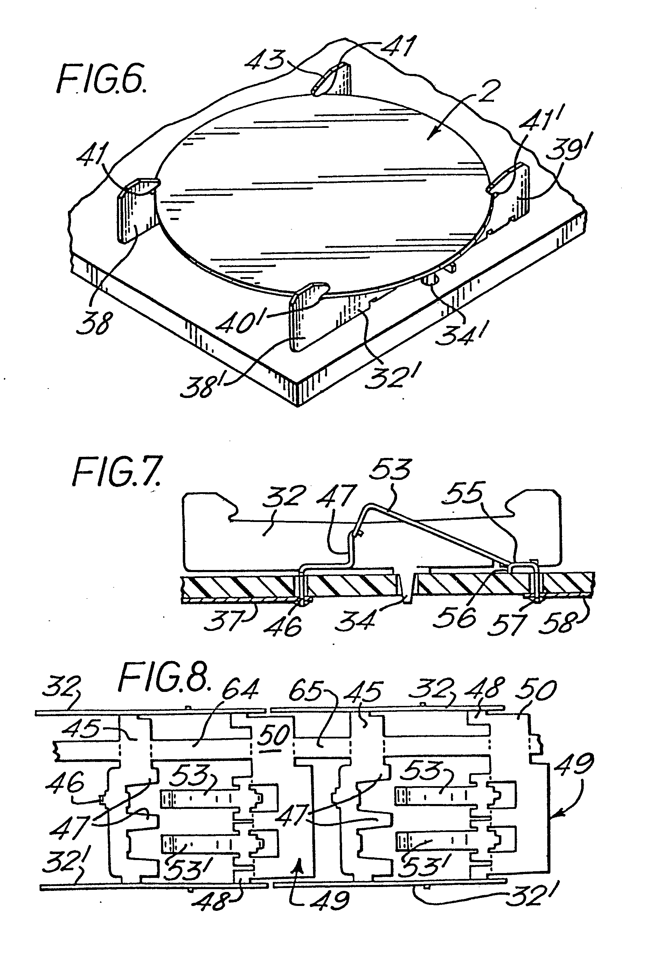

In the second example of the connector shown in Figures 4 to 8, resilient metal strip members 32, 32' have solder tabs 34, 34' extending from respective longitudinal edges for connection to circuit portions 37, 37' respectively and optional, transverse steadying lugs 35, 35'. The ears 38, 39 and 38', and 39' are formed at respective opposite ends of the strip members and provided with opposed hook-forming notches 40, 41 and 40', 41'. Camming guide surfaces 42, 43 and 42', 43' formed on associated ears extend towards the respective notches.

A transverse tie bar 45 integrally joins lower edges of each strip at locations adjacent the solder tabs 34, 34' and a solder tab 46 extends from the bar. A pair of spaced protecting members 47 extend in spaced apart relation from the bar.

A tab 48 extends inwardly from a lower edge of each strip portion and a transverse handling section 49 is integrally joined to each tab by a line of weakness. A manually engageable flange 51 upstands from a transverse edge of the handling section 49. The handling section is also integrally joined by a line of weakness to mounting portions 55, 55' of upwardly inclined contact arms 53, 53' having contact surfaces 54, 54' extending above the plane containing the notches 40, 41 and 40', 41'.

The mounting portions are provided with solder tabs 56, 56' for connection to conductive portions 58, 58'. It should be noted that the contact portions 54, 54' interdigitate with the protecting member 47. The two contact arms are provided to enable a feedback circuit to be connected to the transducer, if desired.

The connectors may be manufactured as a continuous strip as shown in Figure 8. Prior to mounting on a printed circuit board connecting webs 64 and 65 (being part of the carrier strip) are punched out. Subsequently, the tangs 49 of the individual connectors are bent up and the connectors solder tabs soldered in the printed circuit board. Handling section 49 can then be broken away by bending it away from the plane of the printed circuit board.

Assembly with the disc-form transducer is similar to that of the first example.

## Claims

1. An electrical connector for mounting a flat piezo-electric transducer (2) on a printed circuit board (10) comprising first (12, 32) and second (12', 32') stamped and formed metal strip portions having a plurality of coplanar perimetrically spaced, hook-forming portions (20, 20', 21, 21') adjacent their ends at least one of which strip portions is resilient, the strip portions being adapted to be connected to the printed circuit board with the plane containing the hook-forming portions parallel to the printed circuit board, a resilient contact arm (25, 53, 53') adapted to be connected to upstand from the printed circuit board surrounded by the hook-forming portions, the arrangement being such that resilient flexure of the or each strip portion relatively apart to enlarge the perimeter will permit engagement of an edge portion (8) of the transducer by all the hook-forming portions with a central portion of the transducer depressing the contact arm, characterised in that, the resilient strip portion (12 or 12' or 32, 32') extends with its longitudinal axis parallel to the plane containing the hook-forming portions (20, 20', 21, 21') for resilient flexure parallel to the plane of the printed circuit board (10).

2. An electrical connector according to Claim 1 characterised in that, both strip portions (12, 12' or 32, 32') are resilient and are provided with hook-forming portions (20, 21, and 20', 21' or 40, 41, and 40', 41') at respective opposite ends, the strip portions (12, 12' or 32, 32') being adapted intermediate their ends to be connected to the printed circuit board (10) in spaced, parallel relation with the planes of the strips perpendicular to the printed circuit board (10).

3. An electrical connector according to Claim 2, characterised in that, the strip portions (32 and 32') are integrally joined intermediate their ends by a tie bar (45) extending transversely between them.

4. An electrical connector according to Claim 3, characterised in that, a protecting member (47) extends from the tie bar (45) to a location adjacent the contact arm (53 or 53').

5. An electrical connector according to any one of the preceding claims, characterised in that, the hook-forming portions (20, 21 and 20', 21' or 40, 41, and 40', 41') are provided by notches in ears (18, 19, and 18', 19' or 38, 39, 38', 39') at respective opposite ends of each strip portion.

6. An electrical connector according to Claim 5, characterised in that a cam surface (22, 23 and 22', 23' or 42, 43, and 42', 43') extends to each notch.

## Revendications

1. Connecteur électrique pour le montage d'un transducteur piézo-électrique plat (2) sur une carte (10) à circuit imprimé, comprenant des premiers (12, 32) et seconds (12', 32') tronçons de bande métallique emboutis et formés ayant plusieurs portions (20, 20'; 21, 21') formant crochets, coplanaires, espacées périphériquement, adjacentes à leurs extrémités, au moins l'un de ces tronçons de bande étant élastique, les tonçons de bande étant conçus pour être connectés à la carte à circuit imprimé de manière que le plan contenant les portions formant crochets soit parallèle à la carte à circuit imprimé, un bras élastique de contact (25, 53, 53') conçu pour être connecté et pour s'élever de la carte à circuit imprimé, entouré par les portions formant crochets, l'agencement étant tel que le mouvement relatif d'écartement par flexion élastique du ou de chaque tronçon de bande accroisse le périmètre et permette ainsi à toutes les portions formant crochets d'entrer en prise avec un tronçon de bord (8) du transducteur, une partie centrale du transducteur enfonçant le bras de contact, caractérisé en ce que le tronçon élastique de bande (12 ou 12' ou 32, 32') s'étend de manière que son axe longitudinal soit parallèle au plan contenant les portions formant crochets (20, 20', 21, 21') pour une flexion élastique parallèle au plan de la carte (10) à circuit imprimé.

2. Connecteur électrique selon la revendication 1, caractérisé en ce que les deux tronçons de bande (12, 12' ou 32, 32') sonte élastiques et comportent des portions formant crochets (20, 21 et 20', 21', ou 40, 41 et 40', 41') à des extrémités opposées respectives, les portions de bande (12, 12' ou 32, 32') étant conçues pour être connectées, entre leurs extrémités, à la carte (10) à circuit imprimé, à distance et parallèlement aux plans des bandes perpendiculaires à la carte (10) à circuit imprimé.

3. Connecteur électrique selon la revendication 2, caractérisé en ce que les tronçons de bande (32 et 32') sonte reliés entre leurs extrémités par un tirant (45) avec lequel ils sont réalisés d'une seule pièce et que s'étend transversalement entre eux.

4. Connecteur électrique selon la revendication 3, caractérisé en ce qu'un élément (47) de protection s'étend du triant (45) jusqu'à un point adjacent au bras de contact (53 ou 53').

5. Connecteur électrique selon l'une quelconque des revendications précédentes, caractérisé en ce que les portions formant crochets (20, 21 et 20', 21 ou 40, 41 et 40', 41') présentent des encoches ménagées dans des languettes (18, 19 et 18', 19' ou 38, 39 et 38', 39') à des extrémités opposées respectives de chaque tronçon de bande.

6. Connecteur électrique selon la revendication 5, caractérisé en ce qu'une surface de came (22, 23 et 22', 23' ou 42, 43 et 42', 43') s'étend jusqu'à chaque encoche.

## Patentansprüche

1. Elektrischer Verbinder zum Montieren eines flachen piezo-elektrischen Wandlers (2) auf einer gedruckten Schaltungsplatte (10), mit ersten (12, 32) und zweiten (12', 32') ausgestanzten und geformten Metallstreifenteilen, die eine Mehrzahl von in einer Ebene liegenden, mit gegenseitigen Abständen angeordneten, hakenbildenden Teilen (20, 20', 21, 21') in der Nähe ihrer Enden haben, wobei wenigstens einer der Streifenteile nachgiebig ist, und wobei die Streifenteile so ausgebildet sind, daß sie mit der gedruckten Schaltungsplatte so verbunden werden können, daß die Ebene, die die hakenbildenden Teile enthält, parallel zu der gedruckten Schaltungsplatte liegt, und mit einem nachgiebigen Kontaktarm (25, 53, 53'), der so angeschlossen werden kann, daß er von der gedruckten Schaltungsplatte nach oben vorragt und von den hakenbildenden Teilen umgeben ist, wobei die Anordnung so getroffen ist, daß eine nachgiebige Verformung des oder jedes Streifenteils in bezug auf den anderen derart, daß der Abstand vergrößert wird, einen Eingriff eines Randteils (8) des Wandlers mit allen hakenbildenden Teilen ermöglicht, wobei ein mittlerer Teil des Wandlers den Kontaktarm niederdrückt, dadurch gekennzeichnet, daß der nachgiebige Streifenteil (12 oder 12' oder 32, 32') sich mit seiner Längsachse parallel zu der Ebene erstreckt, die die hakenbildenden Teile (20, 20', 21, 21') enthält, wodurch eine nachgiebige Verformung parallel zu der Ebene der gedruckten Schaltungsplatte (10) ermöglicht ist.

2. Elektrischer Verbinder nach Anspruch 1, dadurch gekennzeichnet, daß beide Streifenteile (12, 12' oder 32, 32') nachgiebig sind und mit hakenbildenden Teilen (20, 21 und 20', 21' oder 40, 41 und 40', 41') an den jeweiligen entgegengesetzten Enden versehen sind, wobei die Streifenteile (12, 12' oder 32, 32') so ausgebildet sind, daß sie zwischen ihren Enden mit der gedruckten Schaltungsplatte (10) in gegenseitigem Abstand und parallel zueinander verbunden werden können, wobei die Ebenen der Streifen senkrecht zu der gedruckten Schaltungsplatte (10) stehen.

3. Elektrischer Verbinder nach Anspruch 2, dadurch gekennzeichnet, daß die Streifenteile (32 und 32') zwischen ihren Enden durch einen Verbindungssteg (45) einstückig miteinander verbunden sind, der sich quer zwischen ihnen erstreckt.

4. Elektrischer Verbinder nach Anspruch 3, dadurch gekennzeichnet, daß ein Schutzgleid (47) sich von dem Verbindungssteg (45) zu einer Stelle benachbart dem Kontaktarm (53 oder 53') erstreckt.

5. Elektrischer Verbinder nach irgendeinem der vorhergehenden Ansprüche, dadurch gekennzeichnet, daß die hakenbildenden Teile (20, 21 und 20', 21' oder 40, 41 und 40', 41') durch Kerben in Ohren (18, 19 und 18', 19' oder 38, 39 und 38', 39') an den jeweiligen gegenüberliegenden Enden jedes Streifenteils gebildet sind.

6. Elektrischer Verbinder nach Anspruch 5, dadurch gekennzeichnet, daß eine Nockenfläche (22, 23 und 22', 23' oder 42, 43 und 42', 43') sich zu jeder Kerbe hin erstreckt.

FIG. 1.

FIG. 2.

FIG. 3.

FIG.4.

FIG.5.

FIG.6.

FIG.7.

FIG.8.